# EUROPÄISCHE PATENTSCHRIFT

(11) **EP 4 260 380 B1**
(45) Veröffentlichungstag und Bekanntmachung des Hinweises auf die Patenterteilung: **11.12.2024**
(21) Anmeldenummer: 21790905.0
(22) Anmeldetag: 13.10.2021
(51) Int. Cl.: H01L 31/049, H02S 30/20, H10K 30/88

(54) **TEXTILAUFBAU MIT FLEXIBLEN SOLARZELLEN**
FABRIC STRUCTURE COMPRISING FLEXIBLE SOLAR CELLS
STRUCTURE DE TISSU COMPRENANT DES CELLULES SOLAIRES FLEXIBLES

(30) Priorität: 11.12.2020 DE 102020133068
(43) Veröffentlichungstag der Anmeldung: 18.10.2023
(73) Patentinhaber: Audi AG, 85045 Ingolstadt (DE)
(72) Erfinder: BRYMERSKI, Wojciech, 70806 Kornwestheim (DE); FORSTER, Julia, 78333 Stockach (DE)
(86) Internationale Anmeldenummer: PCT/EP2021/078336
(87) Internationale Veröffentlichungsnummer: WO 2022/122227

(56) Entgegenhaltungen:
- EP-A1- 2 348 543
- WO-A1-2015/110356
- WO-A2-99/61721
- DE-A1- 102010 026 221
- GB-A- 2 574 807

## Beschreibung

Die vorliegende Erfindung betrifft einen Textilaufbau mit flexiblen Solarzellen, ein Verfahren zu dessen Herstellung, sowie den Textilaufbau enthaltende Vorrichtungen.

Es ist bereits vorgeschlagen worden, Solarzellen mit textilen Werkstoffen zu kombinieren.

Aus der DE 10 2010 026 221 A1 ist eine Faltdachanordnung eines Kraftfahrzeugs bekannt mit einem Verdeck, welches mehrere in einer Öffnungsstellung des Verdecks aufeinander faltbare und in sich flexibel ausgebildete Verdecksegmente aufweist, in welchen zumindest ein flexibel ausgebildetes Solarmodul integriert ist. Das Solarmodul ist zwischen einer äußeren UV-transparenten Schicht (z.B. Gießharz, PUR, EVA, PVB...) und einer inneren, flexibel ausgebildeten Schicht (Folie, Gewirke, Gewebe etc.) angeordnet.

Die EP 1 082 502 B1 offenbart eine Markise mit einem Rahmen und einer beweglichen Markisenbespannung, die herausnehmbar und entfernbar ist. Die Markisenbespannung weist flexible Solarmodule auf der Oberseite auf. Die Solarmodule sind als Streifen auf die Markisenbespannung (Textil etc.) aufgebracht und über einen Schutzanstrich (Beschichtung) versiegelt. Der Rahmen enthält einen Walzenkörper, auf dem die Markisenbespannung aufgerollt werden kann. Mindestens eine Speicherzelle ist an die Solarmodule angeschlossen und in der Walze montiert. Sie speichert die von den Solarmodulen erzeugte elektrische Energie. Die Markise kann mit der in der Speicherzelle gespeicherten Energie betrieben werden.

Die EP 3 097 591 A1 betrifft eine hocheffiziente flexible Photovoltaikfolie, die erhalten wird, indem ein sehr flexibler ultradünner Photovoltaikfilm mit einem sehr dünnen prismatischen Antireflexionsfilm kombiniert wird, der die Energie der Sonnenstrahlung absorbiert und den Winkel der Sonnenstrahlen korrigiert.

Die EP 2 348 543 A1 offenbart einen Textilaufbau mit einem Polyestergewebe, auf dem eine Schicht aus Kautschuk angeordnet ist, auf welcher eine Schicht angebracht ist, auf der sich mindestens ein flexibles Dünnschicht-Solarzellenelement befindet.

Vor diesem Hintergrund hat sich die Erfindung die Aufgabe gestellt, einen Solarzellen enthaltenden Textilaufbau, der hohe Verformbarkeit und Robustheit gegenüber Umwelteinflüssen mit hoher Energieeffizienz verbindet, ein Verfahren zu dessen Herstellung, sowie den Textilaufbau enthaltende Vorrichtungen zur Verfügung zu stellen.

Die Aufgabe wird erfindungsgemäß gelöst durch einen Textilaufbau mit den Merkmalen des Anspruchs 1 ein Verfahren mit den Merkmalen des Anspruchs 6, sowie Vorrichtungen mit den Merkmalen der Ansprüche 7-10. Ausgestaltungen und Weiterbildungen der Erfindung ergeben sich aus den abhängigen Ansprüchen, der Beschreibung und der Abbildung.

Gegenstand der Erfindung ist ein Textilaufbau mit einem Polyestergewebe, auf dem eine Schicht aus Butylkautschuk angeordnet ist, auf welcher eine Schicht aus Polyacrylnitril angebracht ist, auf der sich mindestens ein flexibles Dünnschicht-Solarzellenelement befindet, dessen elektrische Anschlussleitungen zwischen Polyacrylnitril- und Butylkautschukschicht geführt sind. Die Kombination von Polyestergewebe, Butylkautschuk und Polyacrylnitril liefert einen dichten Verbund. Damit ist die Solarzelle unanfällig gegen Korrosion bzw. Kurzschluss. Butylkautschuk und Polyacrylnitril ergeben einen Verbund, der dicht und insbesondere flexibel ist.

In einer Ausführungsform beträgt die Schichtdicke des gesamten Verbundes von 1 bis 5 mm. In einer Ausführungsform weist das flexible Dünnschicht-Solarzellenelement eine Schichtdicke von 0,1 bis 0,5 mm auf. In einer Ausführungsform beträgt die Dicke der übrigen Schichten von 0,1 bis 0,5 mm.

In einer Ausführungsform sind die Enden der elektrischen Anschlussleitungen mit einem integrierten Verbindungsstecker gekoppelt. Der Stecker kann über die Trägerschichten (PAN, Butylkautschuk und PES Gewebe) integriert werden oder über den ganzen Verbund inkl. Solarzellen.

In einer Ausführungsform ist das mindestens eine flexible Dünnschicht-Solarzellenelement mittels einer Haftschicht oder einer Druckpaste auf der Schicht aus Polyacrylnitril befestigt.

In einer weiteren Ausführungsform ist auf dem mindestens einen flexiblen Dünnschicht-Solarzellenelement eine transparente Schutzschicht angebracht. In einer Ausführungsform umfasst die transparente Schutzschicht eine transparente Schutzfolie. In einer Ausführungsform ist die transparente Schutzfolie ein Polyolefinfilm oder eine Folie aus einem anderen transparenten Kunststoffmaterial. In einer anderen Ausführungsform besteht die transparente Schutzschicht aus einem transparenten und flexiblen Gießharz.

In einer Ausführungsform ist das mindestens eine flexible Dünnschicht-Solarzellenelement eine hocheffiziente flexible Photovoltaikfolie mit mindestens einer Photovoltaikschicht. In einer Ausführungsform besteht die Photovoltaikschicht aus Platten- oder Schichtphotovoltaikzellen. In einer Ausführungsform sind die Photovoltaikzellen Dünnschichtzellen aus amorphem Silizium. In einer anderen Ausführungsform sind die Photovoltaikzellen Zellen des Kupfer-, Indium-, Gallium-, Selen-Gemischtyps (CIGS), des Cadmiumtelluridtyps (CdTe) oder des Cadmiumselenidtyps (CdS), des bedruckbaren oder nicht bedruckbaren organischen Typs (OPV) oder vom Typ "Farbstoffsensibilisierte Solarzelle" (DSSC, DSC). In einer Ausführungsform ist die Photovoltaikschicht zwischen zwei flexiblen Polymerfilmen eingekapselt. In einer Ausführungsform sind die Polymerfilme Copolymere von Ethylenacrylsäure (EAA) oder Ethylenmethylacrylat (EMA).

Gegenstand der Erfindung ist auch ein Verfahren zur Herstellung des erfindungsgemäßen Textilaufbaus. Bei dem Verfahren wird zunächst auf ein Polyestergewebe eine Schicht aus Butylkautschuk aufgebracht. Auf der Schicht aus Butylkautschuk werden elektrische Anschlussleitungen zum Anschluss mindestens eines Dünnschicht-Solarzellenelements verlegt. Über die elektrischen Anschlussleitungen wird eine Schicht aus Polyacrylnitril so aufgebracht, dass die Enden der elektrischen Anschlussleitungen durch die Schicht aus Polyacrylnitril geführt sind. Auf der Schicht aus Polyacrylnitril wird dann mindestens ein Dünnschicht-Solarzellenelement befestigt und an die elektrischen Anschlussleitungen angeschlossen. In einer weiteren Ausführungsform des Verfahrens wird das andere Ende der elektrischen Anschlussleitungen an einen Verbindungsstecker angeschlossen. In einer Ausführungsform des Verfahrens wird das flexible Dünnschicht-Solarzellenelement mittels einer Haftschicht oder einer Druckpaste auf der Schicht aus Polyacrylnitril befestigt. In einer weiteren Ausführungsform des Verfahrens wird auf dem flexiblen Dünnschicht-Solarzellenelement eine transparente Schutzschicht angebracht. In einer Ausführungsform ist die transparente Schutzschicht eine transparente Schutzfolie. In einer anderen Ausführungsform wird die transparente Schutzschicht durch Aufbringen eines transparenten und flexiblen Gießharzes erzeugt. Zusätzlich oder alternativ kann das mindestens eine Dünnschicht-Solarzellenelement mit dem Verbund aus Polyacralnitril, Butylkautschuk und Polyestergewebe mit Fäden aus Polyester im äußeren Rand des Verbundes vernäht werden. Dadurch wird der Textilaufbau noch etwas stabiler und neigt noch weniger zu Delamination.

Gegenstand der Erfindung sind auch Vorrichtungen, die den erfindungsgemäßen Textilaufbau umfassen bzw. aus diesem gefertigt sind. Dazu gehören ein den erfindungsgemäßen Textilaufbau umfassendes Cabrioverdeck, eine den erfindungsgemäßen Textilaufbau umfassende Carportüberdeckung, ein den erfindungsgemäßen Textilaufbau umfassendes Sonnensegel, oder ein den erfindungsgemäßen Textilaufbau umfassendes Bootssegel.

Zu den Vorteilen der erfindungsgemäßen Lösung zählt, dass der Textilaufbau sehr hohe Umformgrade ohne direkte Schädigung aushalten kann, Wasserdichtheit bzw. Resistenz gegenüber Umwelteinflüssen zeigt, und eine hohe Energieeffizienz aufweist (aktuell ist eine Leistung von ca. 120 W/m² möglich).

Weitere Vorteile und Ausgestaltungen der Erfindung ergeben sich aus der Beschreibung und der beiliegenden Zeichnung.

Es versteht sich, dass die vor anstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand einer Ausführungsform in der Zeichnung schematisch dargestellt und wird unter Bezugnahme auf die Zeichnung weiter beschrieben. Es zeigt:

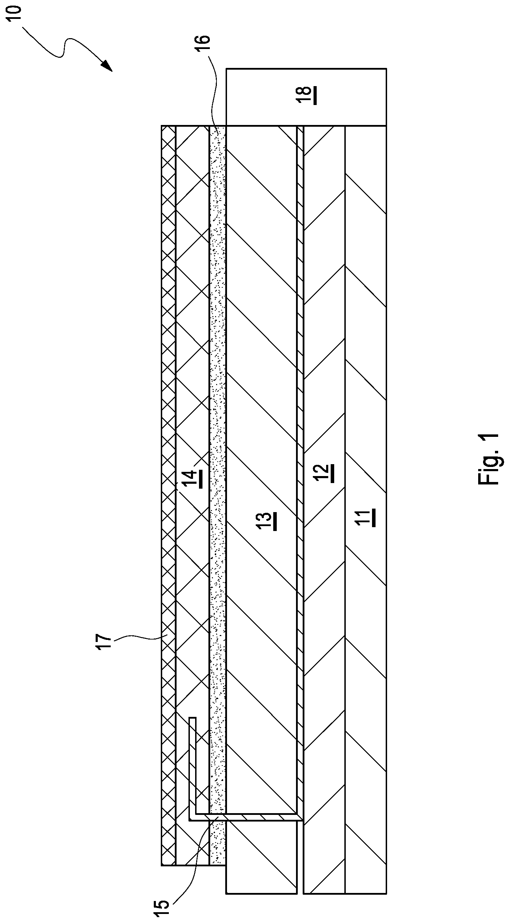

Figur 1 eine Ausführungsform des erfindungsgemäßen Textilaufbaus.

Figur 1 zeigt eine Ausführungsform des erfindungsgemäßen Textilaufbaus 10. Auf einem Polyestergewebe 11 ist eine Schicht 12 aus Butylkautschuk angeordnet, auf welcher eine Schicht 13 aus Polyacrylnitril angebracht ist. Auf der Schicht 13 aus Polyacrylnitril befindet sich mindestens ein flexibles Dünnschicht-Solarzellenelement 14, dessen elektrische Anschlussleitungen 15 zwischen Polyacrylnitril-Schicht 13 und Butylkautschuk-Schicht 12 geführt sind. Die elektrischen Anschlussleitungen 15 sind an ihrem einen Ende an das Dünnschicht-Solarzellenelement 14 und an ihrem anderen Ende an einen Verbindungsstecker 18 angeschlossen. Das flexible Dünnschicht-Solarzellenelement 14 ist mittels einer Haftschicht 16 oder einer Druckpaste 16 auf der Schicht 13 aus Polyacrylnitril befestigt. In der dargestellten Ausführungsform ist auf dem flexiblen Dünnschicht-Solarzellenelement 14 eine transparente Schutzschicht 17 angebracht, beispielsweise eine transparente Schutzfolie. In einer anderen Ausführungsform besteht die transparente Schutzschicht 17 aus einem transparenten und flexiblen Gießharz.

### Bezugszeichenliste

- 10: Textilaufbau
- 11: Polyestergewebe
- 12: Butylkautschukschicht
- 13: Polyacrylnitrilschicht
- 14: Dünnschicht-Solarzellenelement
- 15: Anschlussleitungen
- 16: Haftschicht / Schicht aus Druckpaste
- 17: transparente Schutzschicht
- 18: Verbindungsstecker

## Patentansprüche

1. Textilaufbau (10) mit einem Polyestergewebe (11), auf dem eine Schicht (12) aus Butylkautschuk angeordnet ist, auf welcher eine Schicht (13) aus Polyacrylnitril angebracht ist, auf der sich mindestens ein flexibles Dünnschicht-Solarzellenelement (14) befindet, dessen elektrische Anschlussleitungen (15) zwischen Polyacrylnitril-Schicht (13) und Butylkautschuk-Schicht (12) geführt sind.

2. Textilaufbau (10) nach Anspruch 1, worin das flexible Dünnschicht-Solarzellenelement (14) mittels einer Haftschicht (16) oder einer Druckpaste (16) auf der Schicht (13) aus Polyacrylnitril befestigt ist.

3. Textilaufbau (10) nach Anspruch 1 oder 2, worin auf dem flexiblen Dünnschicht-Solarzellenelement (14) eine transparente Schutzschicht (17) angebracht ist.

4. Textilaufbau (10) nach Anspruch 3, worin die transparente Schutzschicht (17) eine transparente Schutzfolie ist.

5. Textilaufbau (10) nach Anspruch 3, worin die transparente Schutzschicht (17) aus einem transparenten und flexiblen Gießharz besteht.

6. Verfahren zur Herstellung eines Textilaufbaus nach einem der Ansprüche 1 bis 5, bei dem auf ein Polyestergewebe (11) eine Schicht (12) aus Butylkautschuk aufgebracht wird, auf der Schicht (12) aus Butylkautschuk elektrische Anschlussleitungen (15) zum Anschluss mindestens eines Dünnschicht-Solarzellenelements (14) verlegt werden, über die elektrischen Anschlussleitungen (15) eine Schicht (13) aus Polyacrylnitril so aufgebracht wird, dass die Enden der elektrischen Anschlussleitungen (15) durch die Schicht (13) aus Polyacrylnitril geführt sind, und auf der Schicht (13) aus Polyacrylnitril mindestens ein Dünnschicht-Solarzellenelement (14) befestigt und an die elektrischen Anschlussleitungen (15) angeschlossen wird.

7. Einen Textilaufbau nach einem der Ansprüche 1 bis 5 umfassendes Cabrioverdeck.

8. Einen Textilaufbau nach einem der Ansprüche 1 bis 5 umfassende Carportüberdeckung.

9. Einen Textilaufbau nach einem der Ansprüche 1 bis 5 umfassendes Sonnensegel.

10. Einen Textilaufbau nach einem der Ansprüche 1 bis 5 umfassendes Bootssegel.

## Claims

1. Textile structure (10) with a polyester fabric (11), on which a layer (12) of butyl rubber is arranged, on which a layer (13) of polyacrylnitrile is applied, on which at least one flexible thin-film solar cell element (14) is located, whose electrical connecting lines (15) are guided between the polyacrylnitrile layer (13) and butyl rubber layer (12).

2. Textile structure (10) according to claim 1, wherein the flexible thin-film solar cell element (14) is attached to the polyacrylnitrile layer (13) by means of an adhesive layer (16) or a printing paste (16).

3. Textile structure (10) according to claim 1 or 2, wherein a transparent protective layer (17) is applied to the flexible thin-film solar cell element (14).

4. Textile structure (10) according to claim 3, wherein the transparent protective layer (17) is a transparent protective film.

5. Textile structure (10) according to claim 3, wherein the transparent protective layer (17) consists of a transparent and flexible casting resin.

6. Method for producing a textile structure according to any one of claims 1 to 5, in which a layer (12) of butyl rubber is applied to a polyester fabric (11), electrical connecting lines (15) for connecting at least one thin film-solar cell element (14) are laid on the layer (12) of butyl rubber, a polyacrylnitrile layer (13) is thus applied via the electrical connecting lines (15) so that the ends of the electrical connecting lines (15) are guided through the polyacrylnitrile layer(13), and at least one thin-film solar cell element (14) is attached to the polyacrylnitrile layer (13) and is connected to the electrical connecting lines (15).

7. Convertible soft top comprising a textile structure according to any one of claims 1 to 5.

8. Carport cover comprising a textile structure according to any one of claims 1 to 5.

9. Sunshade comprising a textile structure according to any one of claims 1 to 5.

10. Boat sail comprising a textile structure according to any one of claims 1 to 5.

## Revendications

1. Structure textile (10) avec un tissu en polyester (11) sur lequel une couche (12) de caoutchouc butyle est disposée, sur lequel une couche (13) de polyacrylonitrile est appliquée, sur laquelle se trouve au moins un élément de cellule solaire flexible à couche mince (14) dont des lignes de raccordement électriques (15) sont guidées entre la couche de polyacrylonitrile (13) et la couche de caoutchouc butyle (12).

2. Structure textile (10) selon la revendication 1, dans laquelle l'élément de cellule solaire flexible à couche mince (14) est fixé sur la couche (13) de polyacrylonitrile au moyen d'une couche adhésive (16) ou d'une pâte d'impression (16).

3. Structure textile (10) selon la revendication 1 ou 2, dans laquelle une couche de protection transparente (17) est appliquée sur l'élément de cellule solaire flexible à couche mince (14).

4. Structure textile (10) selon la revendication 3, dans laquelle la couche de protection transparente (17) est un film protecteur transparent.

5. Structure textile (10) selon la revendication 3, dans laquelle la couche de protection transparente (17) est constituée d'une résine coulée transparente et flexible.

6. Procédé de fabrication d'une structure textile selon l'une quelconque des revendications 1 à 5, dans lequel une couche (12) de caoutchouc butyle est appliquée sur un tissu en polyester (11), des lignes de raccordement électriques (15) sont posées sur la couche (12) de caoutchouc butyle pour connecter au moins un élément de cellule solaire à couche mince (14), une couche (13) de polyacrylonitrile est appliquée sur les lignes de raccordement électriques (15) de sorte que les extrémités des lignes de raccordement électriques (15) soient guidées à travers la couche (13) de polyacrylonitrile, et au moins un élément de cellule solaire à couche mince (14) est fixé sur la couche (13) de polyacrylonitrile et raccordé aux lignes de raccordement électriques (15).

7. Capote de cabriolet comprenant une structure textile selon l'une quelconque des revendications 1 à 5.

8. Couverture d'abri d'auto comprenant une structure textile selon l'une quelconque des revendications 1 à 5.

9. Auvent comprenant une structure textile selon l'une quelconque des revendications 1 à 5.

10. Voile de bateau comprenant une structure textile selon l'une quelconque des revendications 1 à 5.
